# EUROPEAN PATENT APPLICATION

(11) **EP 1 953 256 A1**
(43) Date of publication of application: **06.08.2008**
(21) Application number: 06832887.1
(22) Date of filing: 17.11.2006
(51) Int. Cl.: C23C 14/34, C04B 35/00, H01B 5/14, H01L 51/50, H05B 33/28

(54) **FIRED MATERIAL AND PROCESS FOR PRODUCING THE SAME**

(30) Priority: 21.11.2005 JP 2005335585; 11.05.2006 JP 2006132323
(71) Applicant: Idemitsu Kosan Co., Ltd., Chiyoda-ku Tokyo 100-8321 (JP)
(72) Inventor: TOMAI, Shigekazu, Sodegaura-shi Chiba 299-0293 (JP); UMENO, Satoshi, Sodegaura-shi Chiba 299-0293 (JP)
(74) Representative: Gille Hrabal Struck Neidlein Prop Roos
(86) International application number: PCT/JP2006/323009
(87) International publication number: WO 2007/058318

(57) **Abstract**

A fired material including at least one metal atom selected from indium, zinc and tin, at least one alkali metal atom selected from cesium, potassium and lithium, and an oxygen atom, wherein the atomic ratio (alkali metal atom)/(metal atom + alkali metal atom) is 0.1 to 80 at.%.

## Description

### TECHNICAL FIELD

The invention relates to a fired material which can be used for electrodes of organic electroluminescent (EL) device or the like.

### BACKGROUND

With the recent diversification of information devices, needs for flat panel displays which are thinner and consume a smaller amount of power than CRTs have increased. Examples of such flat panel displays include liquid crystal displays and plasma displays (PDP). Organic EL devices of self emission type having a clear display and a wide view angle have recently attracted attention.

A cathode for an organic EL device is generally formed by depositing, on an organic layer, a metal with a small work function in a thickness of about 100 nm. Such a cathode is not transparent. If light-transmitting electrodes are used as a cathode and an anode in an organic EL device, the resulting organic EL device becomes a light-transmitting, self-emitting device, and eventually will find wider application.

Patent Document 1 discloses such a transparent organic EL device. The device taught by this document is obtained by forming a light-transmitting thin film with a thickness of several nanometers comprising a metal with a low work function or an alloy thereof between an organic emitting film and a transparent conductive layer (cathode), and providing a transparent conductive layer (anode) formed of indium tin oxide (ITO) on the side of a hole-transporting layer. The organic emitting film comprises an electron-transporting layer, an emitting layer and a hole-transporting layer, and the transparent conductive layer (cathode) comprises ITO. When a transparent conductive layer is used as a cathode, an energy gap between a cathode and an electron-transporting layer becomes too large. As a result, electrons cannot be injected effectively to the organic emitting film, leading to a lowering in luminous efficiency. The device of this patent document was made in an attempt to eliminate such a problem by inserting a thin film of a metal with a low work function or an alloy thereof between the organic emitting film and the transparent conductive layer.

However, it is difficult to form a thin film of a metal with a low work function. Even though a thin film can be formed, the film tends to suffer from oxidation or other problems, and is quite unstable. Therefore, it is extremely difficult to form a transparent conductive layer on the thin film of a metal having such a low work function.

Patent Document 2 has found that a device with an excellent luminous efficiency can be obtained readily and stably by providing, between an organic emitting film including an organic emitting layer and a cathode, an electron-injecting layer comprising an organic metal complex or an organic metal salt of an alkaline metal or an alkaline earth metal, or an electron-injecting layer comprising an oxide or a halide of an alkaline metal or an alkaline earth metal. However, such an electron-injecting layer is required to be controlled to have a small thickness of 0.1 nm to 20 nm, and hence, it was difficult to make the layer have a large area. While a thinner electron-injecting layer improves an electron-injecting efficiency, non-uniform injection of electrons or the generation of dark spots may occur if the thickness is too small. If the film thickness is too large, luminous efficiency lowers and the organic EL device will have a short lifetime.

Under such circumstances, electrode materials having electron-injection properties, transparency and conductivity have been strongly desired.
As such materials, organic EL materials using a cathode obtained by doping ITO with Cs have been reported (Non-Patent Document 1). Specifically, when forming ITO to a film by sputtering, Cs metal is caused to vaporize by blowing an argon gas within the same chamber, whereby an ITO cathode film is doped with Cs cathode film. According to this method, an electrode material having in combination electron injection properties, transparency and conductivity can be obtained. However, this method requires a dedicated apparatus, and the Cs metal, of which the concentration is high, may contaminate the chamber.

Patent Document 1: JP-A-08-185984
Patent Document 2: JP-A-2000-223277
Non-Patent Document 1: Japanese Journal of Applied Physics Vol. 44, No. 8, (2005), 5939

An object of the invention is to provide an electrode excellent in electron-injection properties, transparency and conductivity.
Another object of the invention is to provide a sputtering target and a fired material capable of forming such an electrode, and a method for producing the fired material.

### SUMMARY OF THE INVENTION

The invention provides the following fired material or the like.
1. A fired material comprising at least one metal atom selected from indium, zinc and tin, at least one alkali metal atom selected from cesium, potassium and lithium, and an oxygen atom, wherein the atomic ratio (alkali metal atom)/(metal atom + alkali metal atom) is 0.1 to 80 at.%.
2. The fired material according to 1 which has a volume resistivity of 5 × 10⁻¹ Ω·cm or less.
3. The fired material according to 1 or 2 which contains an oxide of indium and zinc.
4. A method for producing the fired material according to one of 1 to 3 comprising the steps of:
   mixing an oxide of at least one metal selected from indium, zinc and tin and a compound containing at least one alkali metal selected from cesium, potassium and lithium to obtain a mixture;
   molding the mixture to obtain a molded article; and
   firing the molded article.
5. The method for producing the fired material according to 4, wherein the compound containing at least one alkali metal is a compound having a melting point of 500°C to 1400°C.
6. The method for producing the fired material according to 4, wherein the compound containing at least one alkali metal is one or more compounds selected from Cs₂CO₃, CsCl, CsI, Cs₂O₄, CsF, KBr, K₂CO₃, KCl and KF.
7. A sputtering target comprising the fired material according to any one of 1 to 3.
8. A transparent conductive film comprising at least one metal atom selected from indium, zinc and tin, at least one alkali metal atom selected from cesium, potassium and lithium, and an oxygen atom, wherein the atomic ratio (alkali metal atom)/(metal atom + alkali metal atom) is 0.1 to 80 at.%.
9. The transparent conductive film according to 8 which is formed by sputtering using the sputtering target according to 7.
10. The transparent conductive film according to 8 or 9 which has a work function of 5.0 eV or less.
11. An electrode comprising the transparent conductive film according to any one of 8 to 10.

According to the invention, an electrode excellent in electron-injection properties, transparency and conductivity can be provided.
According to the invention, a sputtering target and a fired material capable of producing such an electrode and a method for producing thereof can be provided.

### BEST MODE FOR CARRYING OUT THE INVENTION

The fired material of the invention contains at least one metal atom selected from indium, zinc and tin, at least one alkali metal atom selected from cesium, potassium and lithium, and an oxygen atom.

The metal atoms contained in the fired material of the invention are preferably indium and zinc, or indium and tin.

The alkali metal contained in the fired material of the invention is preferably cesium or potassium, more preferably cesium. A transparent conductive film with a particularly low work function can be obtained when a film is formed from the fired material containing a cesium atom.

In the fired material of the invention, the atomic ratio expressed by (alkali metal atom)/(metal atom + alkali metal atom) is 0.1 to 80 at.%. If the atomic ratio is smaller than 0.1 at.%, the work function of the resultant film cannot be sufficiently lowered. An atomic ratio exceeding 80 at.% makes production of a fired material difficult. Considering the effects brought by incorporating the alkali metal atom and the production of the fired material, the above-mentioned atomic ratio is preferably 0.1 to 50 at.%, more preferably 8 to 46 at.%, and particularly preferably 20 to 40 at.%.
In particular, in the case of the fired material incorporating a cesium atom, it is preferred that the atomic ratio expressed by (cesium atom)/(metal atom + cesium atom) be 8 to 46 at.%, with particular preference of 10 to 30 at.%. By this atomic ratio, the work function of the transparent conductive film can be significantly reduced. Specifically, the work function can be reduced to 4.0 eV or less.

The volume resistivity of the fired material of the invention is preferably 5 × 10⁻¹ Ω·cm or less, more preferably 5 × 10⁻² Ω·cm or less, and particularly preferably 5 × 10⁻³ Ω·cm or less.
If the volume resistivity exceeds 5 × 10⁻² Ω·2- cm, RF sputtering must be conducted since it is difficult to perform DC sputtering. If RF sputtering is conducted, plasma extends towards organic substances, and the organic substances are likely to be damaged.

It is preferred that the fired material of the invention contain an oxide of indium and zinc, or an oxide of indium and tin.
By incorporating an oxide of indium and zinc, or an oxide of indium and tin, the resistance of the fired material can be lowered readily. As a result, it is possible to conduct DC sputtering which is excellent in productivity and exerts less damage on a substrate.

Then, the method for producing the fired material of the invention will be described.
The fired material of the invention can be obtained by a method comprising the steps of mixing an oxide of at least one metal selected from indium, zinc and tin and at least one alkali metal selected from cesium, potassium and lithium to obtain a mixture, molding the mixture to obtain a molded article, and firing the molded article.
A preferred method for producing the fired material is described in detail below.

### (1) Step of preparing raw material

In this step, an oxide of at least one metal selected from indium, zinc and tin and a compound containing at least one alkali metal selected from cesium, potassium and lithium are mixed to obtain a mixture. It is preferred that the mixing be conducted such that the atomic ratio (alkali metal atom)/(metal atom + alkali metal atom) becomes 0.1 to 80 at.%.

The average particle size of this mixture is preferably 0.01 to 10 µm if granulation (explained later) is not performed. More preferably, the average particle size of the mixture is 0.1 to 5 µm. If the average particle size is less than 0.01 µm, agglomeration tends to occur. If the average particle size exceeds 10 µm, mixing may be difficult and a dense fired material may be hard to obtain.

As examples of the compound containing an alkali metal, an oxide, a halide, an inorganic acid salt, a hydroxide or the like of an alkali metal can be used.

The compound containing an alkali metal has a melting point of preferably 500°C to 1.400°C, more preferably 600°C to 1300°C. If the melting point is less than 500°C, the alkali metal tends to sublime. As a result, the mixing ratio may be changed during the production of the fired material.

As the compound containing an alkali metal, it is preferable to use one or more compounds selected from Cs₂CO₃, CsCl, CsI, Cs₂SO₄, CsF, KBr, K₂CO₃, KCl and KF. It is more preferable to use Cs₂CO₃, CsCl, CsI, Cs₂SO₄ and CsF. CS₂CO₃ is particularly preferable since decarbonization is expected during the process of heating. Cs₂CO₄ is preferable, since it is a salt of which the melting point is highest, and dense firing can be expected.

The purity of each starting raw material is preferably 99% or more, more preferably 99.5% or more. If the purity of each starting raw material is less than 99%, it will be difficult to obtain a dense fired material or to obtain a fired material having an intended volume resistivity.

If the compound of an alkali metal is an oxide, powder of each oxide (starting raw material) is put in a mixer such as a ball mill, a jet mill, and a pearl mill in such a predetermined amount that a target with an intended composition can be obtained, followed by pulverization and mixing. The pulverization and mixing are conducted preferably for 1 to 100 hours, more preferably 5 to 50 hours, and particularly preferably 10 to 50 hours. If the pulverization and mixing time is shorter than 1 hour, mixing tends to be insufficient. A pulverization and mixing time exceeding 100 hours is not preferable from an economical point of view. Although there are no particular restrictions on the temperature for pulverization and mixing, it is preferred that pulverization and mixing be performed at room temperature.

If the compound of an alkali metal is not an oxide, a starting raw material is put in a mixer such as a ball mill, a jet mill, and a pearl mill in such a predetermined amount that a target with an intended composition can be obtained, followed by pulverization and mixing to obtain a mixture. The mixture is calcinated, and the resulting calcinated product is pulverized in the above-mentioned mixer or the like, whereby an intended mixture can be obtained. The temperature and time for calcination depends on the kind of the starting raw material. However, it is preferred that calcination be conducted at about 500°C to 900°C for about 1 to 100 hours. If calcination is performed at a temperature lower than 500°C or for a period of time shorter than 1 hour, heat decomposition of the starting raw material tends to be insufficient. On the other hand, if calcination is performed at a temperature exceeding 900°C or for a period of time longer than 100 hours, Cs tends to sublime. It is more preferred that calcination be performed at 600°C to 800°C for 2 to 50 hours.

Although it suffices that the above-mentioned calcination and pulverization be conducted only once, a mixture obtained by pulverizing the calcinated product may be further subjected to calcination and pulverization for a desired number of times. It is also possible to perform the above-mentioned calcination and pulverization using an oxide as the starting raw material for each component to obtain the intended mixture. When a mixture which has already been obtained by calcination and pulverization is calcinated or an oxide is used as a starting raw material, the temperature and time for calcination are preferably about 500°C to 900°C and 1 to 100 hours. If calcination is performed at less than 500°C or for a period of time shorter than 1 hour, thermal decomposition of the starting raw material tends to be insufficient. On the other hand, if calcination is performed at a temperature exceeding 900°C or for a period of time longer than 100 hours, Cs tends to sublime. More preferably, calcination is performed at 500°C to 900°C for 2 to 50 hours.

The intended mixture may be prepared by subjecting a mixture obtained by the method mentioned above to granulation or may be prepared by subjecting the starting raw material of each component to granulation. This granulation can be performed by a known technique such as the spray-dry method. If granulation is performed by the spray-dry method, it is preferable to use a solution obtained by adding a binder such as polyvinyl alcohol to the above-mentioned mixture, or an aqueous or alcohol solution or the like of the starting raw material. Although the conditions for granulation depend on the concentration of the solution and the amount of the binder, the average particle diameter of the granulated product is preferably 1 to 100 µm, more preferably 5 to 100 µm, and particularly preferably 10 to 100 µm. Flowability or fillability during molding may be improved by performing the granulation. If the average particle diameter of the granulated product exceeds 100 µm, flowability or fillability during molding becomes poor, and advantageous effects of granulation cannot be expected.

### (2) Molding step

In this step, the mixture obtained by the above-mentioned step of preparing a raw material is molded to a desired shape prior to firing. Molding may be performed by die molding, cast molding, injection molding, pressure molding or the like. To obtain a fired material having a high relative density, pressure molding such as CIP (cold isostatic pressing), HIP (hot isostatic pressing), and hot pressing is preferred. The molded product may have various shapes suitable for a target. In addition, polyvinyl alcohol, methyl cellulose, polywax, oleic acid or the like may be used as a molding aid. The molding pressure is preferably 10 kg/cm² to 1 t/cm², more preferably 20 kg/cm² to 500 kg/cm². Molding time is preferably 10 minutes to 10 hours. If molding is performed at a pressure of less than 10 kg/cm² or for a period of time shorter than 10 minutes, it may be difficult to obtain a fired material having a high relative density.

### (3) Firing step

In this step, a fired material is obtained by firing the molded product obtained in the above molding step. As the method for firing, HIP, hot pressing, firing at normal pressure or the like may be used. Of these, HIP or hot pressing is preferable to suppress vaporization of Cs. In particular, if a Cs salt with a low melting point is mixed, a temperature for firing is required to be lowered. However, to obtain a denser fired material, hot pressing is preferable. The firing temperature is preferably 1100°C to 1400°C, more preferably 1200°C to 1300°C. If the firing temperature is less than 1100°C, a firing material having a sufficient relative density cannot be obtained. In addition, at such a low firing temperature, it may become difficult to obtain a firing material having an intended volume resistivity even though annealing (explained later) is performed. On the other hand, if the firing temperature exceeds 1400°C, composition tends to change due to sublimation of Cs. Although firing time depends on firing temperature, it is preferred that firing be performed for 1 to 50 hours, more preferably 2 to 30 hours, and particularly preferably 3 to 20 hours. If the firing time is shorter than 1 hour, firing may not be fully conducted. A firing time exceeding 50 hours is not preferable from an economical point of view. Firing is conducted in air or in a reductive atmosphere. Examples of the reductive atmosphere include an atmosphere of a reductive gas such as H₂, methane and CO, and an atmosphere of an inert gas such as Ar and N₂.

If a fired material obtained after the above-mentioned steps of preparing a raw material, molding and firing has a volume resistivity exceeding 5 × 10⁻² Ω·cm, a fired material having a volume resistivity of 5 × 10⁻² Ω·cm or less can be obtained by performing an annealing step described below.

### (4) Annealing step

In this step, when a fired material obtained by the above-mentioned firing step has a volume resistivity exceeding 5 × 10⁻² Ω·cm, the volume resistivity is lowered by reducing the fired material, whereby a fired material having an intended volume resistivity is obtained. Annealing is performed preferably under vacuum or in a reductive atmosphere in a furnace such as a firing furnace and a reduction furnace for hot pressing. Examples of the reductive atmosphere include an atmosphere of a reductive gas such as H₂, methane and CO, and an atmosphere of an inert gas such as Ar and N₂.

If annealing is performed under vacuum, the annealing temperature is preferably 200°C to 1000°C, more preferably 200°C to 700°C, still more preferably 200°C to 500°C. If the annealing temperature is less than 200°C, reduction may be insufficient. An annealing temperature exceeding 1000°C, the cesium component in a fired material may sublime, causing the composition to be changed. The annealing time is preferably 1 to 50 hours, more preferably 2 to 30 hours, and still more preferably 3 to 20 hours. If the annealing time is less than 1 hour, sufficient reduction may not be performed. An annealing time exceeding 50 hours is not preferable from an economical point of view.

If annealing is performed under a reductive atmosphere, the annealing temperature is preferably 200°C to 1000°C, more preferably 300°C to 1000°C, and still more preferably 400°C to 1000°C. If the annealing temperature is lower than 200°C, sufficient reduction may not be performed, and if the annealing temperature exceeds 1000°C, the Cs component may be vaporized. The annealing time is the same as mentioned above. Specifically, the annealing time is preferably 1 to 50 hours, more preferably 2 to 30 hours, and still more preferably 3 to 20 hours. After the above-mentioned annealing, a fired material generally has a color which is darker than before annealing.

The intended fired material of the invention can be obtained by the above-mentioned steps of preparing a raw material, molding and firing, or by the above-mentioned annealing step after the firing if need arises. This fired material preferably has a volume resistivity of 5 × 10⁻²Ω·cm or less. Extraordinary discharge is hardly induced or cracking hardly occurs even when this fired material is used as a target for forming a film by the DC sputtering method. In addition, this target is capable of producing stably a transparent conductive film with a work function of 3.5 eV to 4.5 eV by sputtering methods such as DC sputtering and high-frequency sputtering.

The transparent conductive film of the invention can be obtained by sputtering using a sputtering target formed of the above-mentioned fired material.
The work function of the transparent conductive film is preferably 5.0 eV or less, more preferably 4.4 eV or less, and particularly preferably 4.0 eV or less.
If the work function exceeds 5.0 eV, electron-injection efficiency may be lowered.

The transparent conductive electrode of the invention is preferable as an electrode, especially as a cathode.
For instance, the transparent conductive electrode can be used as an electrode of an organic EL device. In an organic EL device, an emitting layer is between a pair of electrodes. The transparent conductive electrode of the invention can be used as at least one of them, preferably a cathode.
If a transparent electrode is used as a cathode of a top-emitting organic EL device, the cathode can be an electrode through which light is outcoupled.

In the transparent conductive film of the invention, the atomic ratio expressed as (alkali metal atom)/(metal atom + alkali metal atom) is 0.1 to 80 at.%. Taking into consideration the lowering of the work function by incorporating an alkali metal, the above-mentioned atomic ratio is preferably 10 to 75 at.%, more preferably 20 to 60 at.%.
As mentioned above, when a cesium atom is incorporated, the atomic ratio expressed by (cesium atom)/(metal atom + cesium atom) is preferably 8 to 46 at.% to significantly lower the work function of the transparent conductive film.

The transparent conductive film is not limited to those prepared using the sputtering target comprising the above-mentioned fired material. As the other film-forming method, a pelletized fired material is formed to a film by vacuum deposition or ion plating using an electron beam. Film formation may be conducted using pellets of a compound containing an alkali metal atom together with a sputtering target comprising the fired material. By this method, a transparent conductive film with a high alkali metal content can be prepared even when a fired material with a low alkali metal content is used.

### EXAMPLES

### Example 1

### (1) Preparation of raw material

As shown in Table 1, 300 g of indium oxide (In₂O₃) powder with a purity of 99.8% (average particle size: 1 µm), 5 g of zinc oxide (ZnO) powder with a purity of 99.5% (average particle size: 1 µm) and 170 g of cesium carbonate with a purity of 99.5% (average particle size: 1 µm) were used as starting raw materials. These starting raw materials were put in a polyimide-made pot together with ethanol and alumina balls, and mixed for 2 hours by means of a planet ball mill. The resulting mixture in the form of powder was calcinated at 1000°C for 5 hours in an atmosphere of air. The calcinated product was again put in a polyimide-made pot together with ethanol and alumina balls, followed by pulverizing with a planet ball mill for 2 hours. Water and polyvinyl alcohol were added to the powder obtained as above, mixed, and granulated by means of a spray dryer, whereby a mixture with an average particle size of 10 µm of indium oxide, zinc oxide and cesium carbonate was obtained.

### (2) Molding

The mixture in the form of powder was placed in a mold, and subjected to a preliminary molding at a pressure of 100 kg/cm² using a metal pressing machine, followed by compaction at a pressure of 4 t/cm² by means of a cold isostatic pressing machine. As a result, a disc-like molded article with a diameter of 4.1 inches and a thickness of 5.3 mm was obtained.

### (3) Firing

The molded article obtained above was put in a firing furnace, and subjected to firing at normal pressure in air at 1300°C for 4 hours, whereby a fired material was obtained. Then, the surface of the fired material was polished such that the diameter became 4 inches and the thickness became 5 mm, whereby a target made of the intended fired material (relative density: 88%) was obtained. A test piece (20 mm × 40 mm × 5 mm) was cut out from the above target, and the volume resistivity thereof was measured by the four-probe method. The composition of this test piece was analyzed by ICP (inductively coupled plasma spectrometry) analysis by means of SPS-1500VR manufactured by Seiko Instrument Inc. Based on this results, the atomic ratio of Cs, Cs/(In+Zn+Cs) was obtained. The results are shown in Table 1.

### (4) Formation of transparent conductive film

Using a disc-shaped target formed of a fired material with a diameter of 4 inches and a thickness of 5 mm obtained in (1) to (3) above, a 100 nm-thick transparent conductive film was formed on non-alkaline glass with a dimension of 5 cm (length) × 5 cm (width) × 1 mm (thickness) (#7059, manufactured by Corning Incorporated) by DC magnetron sputtering under the following conditions:

### Sputtering apparatus: HSM552 (manufactured by Shimadzu Corporation)

Target size: 4 inches in diameter and 5 mm in thickness
Discharging method: DC magnetron
Discharging current: 0.2 A
Background pressure: 5 × 10⁻⁴ Pa
Introduction gas (atmospheric gas): Mixture of Ar (97 vol%) + 02 (3 vol%)
Gas flow rate: 10 sccm
Pre-sputtering pressure: 2 × 10⁻¹ Pa
Pre-sputtering time: 5 minutes
Sputtering pressure: 2 × 10⁻¹ Pa
Sputtering time: 10 seconds
Substrate temperature: room temperature

As for the transparent conductive films obtained under the above conditions, the work function and volume resistivity were obtained. The results are also shown in Table 1. The work function was measured by AC-1 manufactured by Riken Keiki Co., Ltd.

### Examples 2 to 11

In each of Examples 2 to 11, two targets formed of a fired material were obtained by preparing a raw material, molding and firing in the same manner as in Example 1, except that the materials shown in Table 1 were used as the starting raw materials. One of these two targets was used for the measurement of the volume resistivity and composition analysis in the same manner as in Example 1. Using the other target, a transparent conductive film was formed in the same manner as in Example 1. The results obtained are shown in Table 1.

### Comparative Example 1

Two targets formed of a fired material were obtained by preparing a raw a material, molding and firing in the same manner as in Example 1, except that indium zinc oxide (IZO) was used. One of these two targets was used for the measurement of the volume resistivity in the same manner as in Example 1. Using the other target, a transparent conductive film was formed in the same manner as in Example 1. The results obtained are shown in Table 1.

**Table 1**

| | Material Powder | Melting point of alkali metal-containing compound (°C) | Total alkali metal atom/ (Total metal atom + Total alkali metal atom) (atm%) | Volume resistivity of target (Ω· cm) | Work function of thin film (eV) | Volume resistivity of thin film (Ω· cm) |
|---|---|---|---|---|---|---|
| Example 1 | Sn₂O₃,ZnO,Cs₂CO₃ | 610 | 45.6 | 3.3 × 10⁻² | 3.5 | 0.8 × 10⁻² |
| Example 2 | In₂O₃, ZnO, CsCl | 646 | 22.5 | 3.1 × 10⁻² | 3.9 | 1.1 × 10⁻² |
| Example 3 | In₂O₃, SnO₂, CsI | 621 | 13.8 | 2.8 × 10⁻² | 3.9 | 1.3 ×10⁻² |
| Example 4 | In₂O₃,Cs₂SO₄ | 1016 | 14.4 | 3.0 ×10⁻² | 4.0 | 1.0 ×10⁻² |
| Example 5 | In₂O₃, SnO₂, CsF | 684 | 33.5 | 1.8 × 10⁻² | 3.8 | 0.9 × 10⁻² |
| Example 6 | In₂O₃, SnO₂, KBr | 730 | 24.4 | 3.3 ×10⁻² | 4.2 | 2.3 × 10⁻² |
| Example 7 | In₂O₃, ZnO, K₂CO₃ | 891 | 33.2 | 3.3 × 10⁻² | 4.2 | 1.5 × 10⁻² |
| Example 8 | In₂O₃, ZnO, KCl | 776 | 49.9 | 5.0 ×10⁻² | 4.3 | 3.6 × 10⁻² |
| Example 9 | In₂O₃, SnO₂, KF | 830 | 8.8 | 3.8 × 10⁻² | 4.2 | 1.8 × 10⁻² |
| Example 10 | In₂O₃, SnO₂, CsNO₃ | 339 | 0.8 | 0.9 × 10⁻² | 4.5 | 0.09 × 10⁻² |
| Example 11 | In₂O₃, Li₂CO₃ | 618 | 30.0 | 5.0 × 10⁻² | 4.2 | 1.8 ×10⁻² |
| Com. Ex. 1 | In₂C₃, ZnO | | 0 | 0.2 × 10⁻² | 4.6 | 0.05 × 10⁻² |
| Example 16 | In₂O₃, SnO₂, Cs₂CO₃ | 610 | 43.8 | 1.6 × 10⁻² | 3.9 | 0.7 × 10⁻² |
| Example 17 | In₂O₃, SnO₂, Cs₂SO₄ | 1016 | 42.8 | 1.3 × 10⁻² | 3.9 | 0.6 ×10⁻² |
| Example 18 | In₂O₃,SnO₂,Cs₂SO₄ | 1016 | 3.0 | 0.2 × 10⁻² | 4.2 | 0.1 × 10⁻² |
| Example 19 | In₂O₃, SnO₂, CS₂SO₄ | 1016 | 8.0 | 0.09 × 10⁻² | 4.0 | 0.08 × 10⁻² |

As shown in Table 1, each of the targets prepared in Examples 1 to 11 hardly suffered induction of extraordinary discharge or cracking of a target, when they were used as a target for forming a transparent conductive film by DC magnetron sputtering. The reason is that the volume resistivity of each target was as low as 5.0 × 10⁻² Ω·cm or less.

The transparent conductive film prepared in Examples 1 to 11 had a low work function of 3.5 eV to 4.5 eV, which was low as compared with that of IZO or ITO. Such a transparent conductive film is suitable for use as a cathode of a top-emission organic EL device since it has electron-injection properties, transparency and conductivity in combination.

### Example 12

An alloy (Ag:Pd:Cu=98:1:1) which contains silver as the main component and also contains palladium and copper was formed to a film with a thickness of 200 nm by sputtering. Subsequently, a 30 nm-thick thin film was stacked on the surface (first surface) of this film by sputtering using an IZO (In₂O₃:ZnO=90:10 wt%) target. The film of a palladium-copper alloy and the IZO film functioned as an anode.

Then an EL device was formed on this anode. In preparing an organic EL device, a blue organic EL device was formed by a series of steps while maintaining the vacuum condition. The conditions for forming each layer were as follows:
[First hole-injecting layer]
   4,4',4''-tris[N-(3-methylphenyl)-N-phenylamino]-triphenylamine
   Deposition speed: 0.1 to 0.3 nm/s, thickness: 60 nm
[Second hole-injecting layer]
   4,4'-tris[N-(3-naphthyl)-N-phenylamino]biphenyl
   Deposition speed: 0.1 to 0.3 nm/s, thickness: 2.0 nm
[Emitting layer (host/dopant)]
   Thickness: 40 nm
   Host: 4,4'-bis(2,2-diphenylvinyl)biphenyl
   Deposition speed: 0.4 nm/s
   Dopant: 4,4'-bis(2-(4-(N,N-di-p-tolyl)phenyl)vinyl)biphenyl Deposition speed: 0.01 nm/s, dopant concentration: 2.5 wt%
[Electron-transporting layer]
   Tris(8-quinolinol)aluminum
   Deposition speed: 0.1 to 0.3 nm/s, thickness: 20 nm

A transparent electrode made of an oxide of In, Zn and Cs was formed thereon as a cathode in a thickness of 100 nm using a sputtering target prepared in Example 1. An electric currency of 25 mA/cm² was applied between the anode and the cathode of the resulting organic EL electrode. The driving voltage was 6.5 V, and light emitted through the cathode had a luminance of 930 cd/m². A significant amount of light which traveled to the anode was reflected. The reflected light then reversely traveled and emitted through the cathode. Excellent carrier-injection properties and emission properties could be confirmed. No dark spots were observed on the emitting surface. The results of the evaluation of the resulting organic EL device are shown in Table 2.

### Comparative Example 2

An organic EL device was fabricated and evaluated in the same manner as in Example 12, except that a transparent electrode was formed using a sputtering target prepared in Comparative Example 1. The results obtained are shown in Table 2.

**Table 2**

| | Cathode material | Initial luminance (cd/m²) | Driving voltage (V) | Evaluation of EL device |
|---|---|---|---|---|
| Example 12 | IZO-Cs | 930 | 6.5 | Excellent |
| Com. Ex. 2 | IZO | 250 | 10.2 | Poor |
| Example 20 | ITO-Cs | 940 | 6.4 | Excellent |

### Example 13

An IZO target and CsF pellets in a number shown in Table 3 were installed in a sputtering apparatus and DC magnetron sputtering was performed under the following conditions, whereby a 100 nm-thick transparent conductive film was formed on non-alkaline glass (#7059, manufactured by Corning Incorporated) with a size of 5 cm (length) × 5 cm (width) × 1.1 mm (thickness).
The film formation condition, ratio of Cs atoms, and work function of the resulting transparent conductive film are shown in Table 3.

### Sputtering apparatus: HSM552 (manufactured by Shimadzu Corporation)

IZO target size: 5 inches in diameter, 5 mm in thickness
CsF pellet size: 10 mm in diameter, 5 mm in thickness
Location of pellet: 10 mm away from erosion
Discharging method: DC magnetron
Background pressure (back pressure): 3 × 10⁻⁴ Pa
Introduction gas (atmosphere gas): Mixture of Ar (99 vol%) and O₂ (1 vol%)
Gas flow rate: 10 sccm
Sputtering pressure: 2.7 × 10⁻¹ Pa ± 20%
Sputtering time: 4 minutes and 42 seconds

**Table 3**

| | Target | Number of pellets (CsF) | Discharge gas | Discharge | Background pressure | Cs atoms/total metal atoms (atm%) | Work function of thin film (eV) |
|---|---|---|---|---|---|---|---|
| Example 13 | IZO | 4 | 1% O₂, 99% Ar | 150 W | 3 × 10⁻⁴ Pa | 51.7 | 4.0 |
| Example 14 | IZO | 4 | 100% Ar | 700 mA | 4.9 × 10⁻⁴ Pa | 74.6 | 3.8 |
| Example 15 | IZO | 2 | 100% Ar | 700 mA | 2.9 × 10⁻⁴ Pa | 78.0 | 4.4 |

### Examples 14 and 15

As shown in Table 3, a transparent conductive film was prepared and evaluated in the same manner as in Example 13, except that the conditions for film formation were changed to those shown in Table 3. The results are shown in Table 3.

### Examples 16 to 19

### (1) Preparation of raw material

A raw material was prepared in the same manner as in Example 1(1), except that the following powder was used as the starting raw material.

### Example 16: In₂O₃, SnO₂, Cs₂O₃

### Examples 17-19: In₂O₃, SnO₂, Cs₂SO₄

### (2) Molding and firing

The above mixture powder was molded by means of a hot pressing machine.
Specifically, the mixture powder was put in an aluminum mold with an inner diameter of 60 mm, and molded under the following conditions. In this step, firing was also conducted.
Temperature elevating rate: 5°C/min
Arrival temperature: 1200°C
Holding time: 1 hour
Pressure: 10 MPa
Cooling rate: 5°C/min
As a result, a target made of an intended fired material (relative density: 95%) was obtained.

A test piece with a size of 20 mm × 40 mm × 5 mm was cut out from the above target, and evaluated in the same manner as in Example 1. The results are shown in Table 1.

### Example 20

An organic EL device was fabricated in the same manner as in Example 12, except that the sputtering target produced in Example 17 was used as the cathode. The results are shown in Table 2.

### INDUSTRIAL APPLICABILITY

A transparent conductive film obtained from the fired material of the invention is suitable for use in an organic EL device, displays such as liquid crystal displays, touch panels, solar cell, or the like.

## Claims

1. A fired material comprising at least one metal atom selected from indium, zinc and tin, at least one alkali metal atom selected from cesium, potassium and lithium, and an oxygen atom, wherein the atomic ratio (alkali metal atom)/(metal atom + alkali metal atom) is 0.1 to 80 at.%.

2. The fired material according to claim 1 which has a volume resistivity of 5 × 10⁻¹ Ω·cm or less.

3. The fired material according to claim 1 or 2 which contains an oxide of indium and zinc.

4. A method for producing the fired material according to one of claims 1 to 3 comprising the steps of:
mixing an oxide of at least one metal selected from indium, zinc and tin and a compound containing at least one alkali metal selected from cesium, potassium and lithium to obtain a mixture;
molding the mixture to obtain a molded article; and
firing the molded article.

5. The method for producing the fired material according to claim 4, wherein the compound containing at least one alkali metal is a compound having a melting point of 500°C to 1400°C.

6. The method for producing the fired material according to claim 4, wherein the compound containing at least one alkali metal is one or more compounds selected from Cs₂CO₃, CsCl, CsI, Cs₂O₄, CsF, KBr, K₂CO₃, KCl and KF.

7. A sputtering target comprising the fired material according to any one of claims 1 to 3.

8. A transparent conductive film comprising at least one metal atom selected from indium, zinc and tin, at least one alkali metal atom selected from cesium, potassium and lithium, and an oxygen atom, wherein the atomic ratio (alkali metal atom)/(metal atom + alkali metal atom) is 0.1 to 80 at.%.

9. The transparent conductive film according to claim 8 which is formed by sputtering using the sputtering target according to claim 7.

10. The transparent conductive film according to claim 8 or 9 which has a work function of 5.0 eV or less.

11. An electrode comprising the transparent conductive film according to any one of claims 8 to 10.
